(19) Europäisches Patentamt / European Patent Office / Office européen des brevets

(11) **EP 4 412 018 A1**

(12) **EUROPEAN PATENT APPLICATION**

(43) Date of publication:
**07.08.2024 Bulletin 2024/32**

(21) Application number: **23154525.2**

(22) Date of filing: **01.02.2023**

(51) International Patent Classification (IPC):
**H02H 3/40** $^{(2006.01)}$     **H02H 3/38** $^{(2006.01)}$
**G01R 31/08** $^{(2020.01)}$

(52) Cooperative Patent Classification (CPC):
**H02H 3/405; G01R 31/085; G01R 31/088;**
**H02H 3/387**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Hitachi Energy Ltd**
**8050 Zürich (CH)**

(72) Inventor: **Gajic, Zoran**
**723 47 Västerås (SE)**

(74) Representative: **AWA Sweden AB**
**Box 45086**
**104 30 Stockholm (SE)**

(54) **A METHOD OF DETECTING A FAULT IN A PROTECTED LINE IN A POWER TRANSMISSION SYSTEM**

(57) The present disclosure relates to a method of detecting a fault in a protected line (114) constituting at least a portion of a transmission line (101) in an alternating current, AC, power transmission system (100). The transmission line has at least one phase, and the AC power transmission system has at least one intelligent electric device, IED, (111, 112) connected with the transmission line. The method comprises:
- determining, for each phase, based on measurements at the at least one IED of at least one of a phase voltage and a phase current, at least one electric parameter;
- determining sequence components at a chosen point of the transmission line, on basis of the electric parameters;
- determining, for each phase, an operating quantity, OP, on basis of at least one of a first and a second sequence component of the sequence components;
- determining, for each phase, a restraining quantity, RST, on basis of a third sequence component of the sequence components; and
- comparing, for at least one phase, a property of the OP with a corresponding property of an associated RST, which is the RST for the same phase as the OP.

Fig. 3

## Description

## Technical field

The present disclosure relates to a method of detecting a fault in a protected line constituting at least a portion of a transmission line in an alternating current, AC, power transmission system.

## Background

In an AC power transmission system, such as a high voltage (HV) or a medium voltage (MV) power transmission system, there is a risk for major short-circuit faults, e.g. from a phase to ground or between phases. Such faults have to be detected and remedied as soon as possible. Therefore, the transmission lines are monitored. Prior art solutions typically utilize measurements of current or impedance. They have clear shortcomings. For example, to identify a position of a fault along the transmission line, there may be a need of sending measurement values between devices at different ends of the transmission line. Additionally, as regards impedance measurements the prior art methods have shortcomings regarding e.g. high-impedance faults, semaphore effect due to remote end infeed, impedance measurement even for the healthy phases, etc.

## Summary

In view of the above, it is an object of the present disclosure to provide an improved method of detecting faults on the protected line.

To achieve this object, and also other objects that will be evident from the following description, a method as defined in claim 1 is provided according to the present disclosure. Preferred variants of the method will be evident from the dependent claims.

More specifically, there is provided, according to a first aspect of the present disclosure, a method of detecting a fault in a protected line constituting at least a portion of a transmission line in an alternating current, AC, power transmission system, the transmission line having at least one phase, and the AC power transmission system having at least one intelligent electric device, IED, connected with the transmission line. The method comprises determining, for each phase, based on measurements at the at least one IED of at least one of a phase voltage or a phase current, at least one electric parameter; determining sequence components at a chosen point of the transmission line, by means of the electric parameters; determining, for each phase, an operating quantity, OP, on basis of at least one of a first and a second sequence component of the sequence components; determining, for each phase, a restraining quantity, RST, on basis of a third sequence component of the sequence components; and comparing, for at least one phase, a property of the OP with a corresponding property of an associated RST, which is the RST for the same phase as the OP. The configuration of the operating quantity/-ies and restraining quantity/-ies and comparing them with each other in different ways enable reliable determinations of whether a fault has occurred as well as other transmission line properties related to the fault. The detection relying on uncertain calculations of impedances is thereby avoided. It should be noted that for the purposes of this application, the sequence components will also be called sequence voltages and sequence currents, depending on whether they are based on measured voltages or measured currents.

When the chosen point of the transmission line is a reach point, RP, at a distance from the IED, the method may further comprise determining whether at least one OP has a value exceeding a first threshold. If affirmative, i.e. if at least one OP has a value exceeding the first threshold, then a fault has occurred. The threshold is set at a level that gives a significant likelihood of correctness in order to reduce a risk of measurement errors.

Further, when the chosen point of the transmission line is a reach point, RP, at a distance from the IED, the method may further comprise determining in which phase the fault has occurred.

The determination of in which phase the fault has occurred may comprise selecting the OP which has the largest value and determining a phase angle difference between the selected OP and the associated RST, i.e. the RST which has been determined for the same phase as the selected OP. The fault has occurred in the phase that the OP relates to if a phase angle difference is within a fault interval around 180 degrees. Additionally, the fault has occurred in at least one of the other phases if the phase angle difference is within a fault interval around 0 degrees.

When the chosen point of the transmission line is at the IED, the method may further comprise determining in which phase the fault has occurred.

The determination of in which phase the fault has occurred may comprise determining, for each OP, a phase angle difference between the OP and the associated RST, wherein the fault has occurred in the phase that the OP relates to if the phase angle difference is within a fault interval around 180 degrees.

The determination of in which phase the fault has occurred may be preceded by determining whether a magnitude of the OP and a magnitude of the associated RST, for at least one of the phases, both exceed a second threshold, and, if affirmative, i.e. if they do exceed the second threshold, determining that a fault has occurred. The electric parameter may be based on a phase current, and the method may further comprise determining whether a magnitude of the OP and a magnitude of the associated RST, related to at least one phase, both exceed a third threshold, and whether a maximum phase current exceeds a fourth threshold.

When the chosen point of the transmission line is a reach point, RP, at a distance from the IED, the method may comprise determining whether a magnitude of the OP is bigger than a magnitude of the associated RST, and, if affirmative, determining that an unsymmetrical fault has occurred within a set reach of the distance protection.

When the chosen point of the transmission line is at the IED, the method may comprise determining whether a fault has occurred in a forward direction or in a reverse direction along the transmission line, comprising determining at least two relations of a group of relations. The group of relations may comprise:

$$U_1@IED \geq U_1@RP,$$

$$U_2@IED \leq U_2@RP,$$

and

$$U_0@IED \leq U_0@RP,$$

wherein $U_1@IED$, $U_2@IED$, and $U_0@IED$ are respective magnitudes of the sequence voltages at the IED, and $U_1@RP$, $U_2@RP$, and $U_0@RP$ are respective magnitudes of the sequence voltages at a reach point, RP, at a distance from the IED, and determining that the fault is in forward direction if the at least two relations are true, and that the fault is in reverse direction if the at least two relations are false.

The operation of determining, for each phase, at least one electric parameter may comprise determining a phasor for each electric parameter.

The operation of determining sequence components may comprise determining sequence components for positive, negative, and zero sequence.

The first and second sequence components may be for the negative and zero sequences, and the third sequence component may be for the positive sequence.

According to a second aspect of the present disclosure, there is provided a computer program product comprising instructions which, when downloaded into an intelligent electronic device, connectable to a transmission line of a power transmission system, cause the intelligent electronic device to carry out the method set forth above.

**Brief description of the Drawings**

The present disclosure will by way of example be described in more detail with reference to the appended drawings, which show example embodiments of the disclosure.

    Fig. 1 illustrates some basic parts of a transmission system.

    Fig. 2 is a schematic flow chart of the method according to the present disclosure.
    Fig. 3 schematically illustrates sequence voltage profiles occurring in the transmission system when different kinds of faults have occurred.
    Fig. 4 schematically illustrates calculated sequence voltages in the transmission system when different kinds of faults have occurred between a measurement position and a reach point.
    Figs. 5 and 6 illustrate phase angle differences for different fault situations.
    Fig. 7 illustrates a computer program product.

**Detailed description**

The present disclosure will now be described more fully hereinafter with reference to the accompanying drawings, in which currently preferred embodiments of the disclosure are shown. This disclosure may, however, be embodied in many different forms and should not be construed as limited to the embodiments set forth herein; rather, these embodiments are provided for thoroughness and completeness, and fully convey the scope of the disclosure to the skilled person.

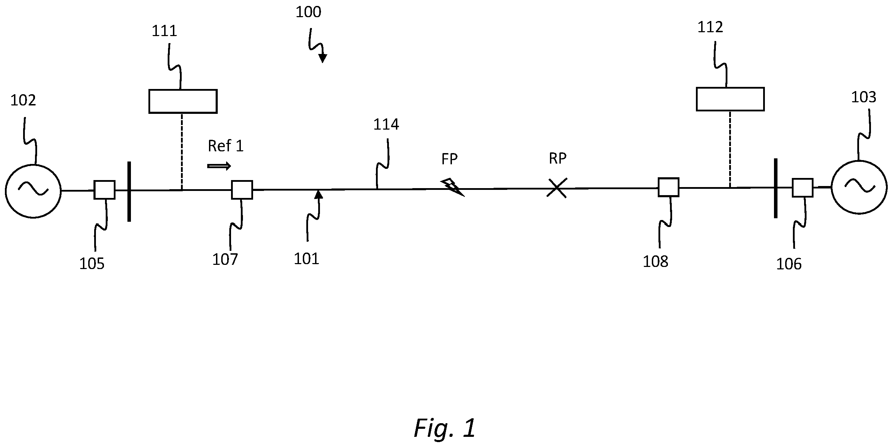

Fig. 1 shows a most general example of a power transmission system 100 comprising a transmission line 101, having one or more phases, for example three phases, and at least two ends. In the illustrated example there are two ends. An electrical apparatus 102, 103 is connected to the transmission line 101 at each end thereof. The electrical apparatus 102, 103 may be an electrical source or an electrical load. The transmission line 101 is provided with one or more switching devices 105, 106, 107, 108 allowing restriction of the flow of current in the power transmission system 100. A fault detection system for the power transmission system 100 comprises one or more Intelligent Electrical Devices (IEDs) 111, 112. Each IED 111, 112 is connected to the transmission line 101, typically at an end thereof, either directly or via some other device, and is arranged to monitor the electrical activity in the transmission line 101, for instance by means of measuring currents and voltages in the transmission line 101 and using the measurements to detect abnormalities. Therefore, for the purposes of this disclosure, the portion of the transmission line 101 where an IED 111, 112 is connected is called a measurement point. Furthermore, the IED 111, 112 is arranged to detect a fault in the transmission line 101 and is arranged to switch one or more of the switching devices 105-108. It should be noted that the transmission line 101, or a portion thereof, that is monitored by the IED 111, 112 constitutes the protected line 114.

As understood by the person skilled in the art the overall structure of the power transmission system shown in Fig. 1 is a mere example among an almost infinite number of different variants. To give just a brief view of the variety, and in addition to what has been described above, the power transmission system may be a part of or connected to the grid, the power sources may be different kinds of power sources such as wind power plants, solar power plants, nuclear power plants, a transformer, etc., the loads may be different kinds of loads such as a production site, etc. The power transmission system may comprise a plurality of transmission lines, etc. The transmission line may be an HV AC line or an MV AC line, it may extend between power sources, between a power source and a load, etc., and, thus, as recognized above, it may constitute what is also referred to as a distribution line. Further, the transmission line may be, for instance, a power cable or an overhead line. The length of the transmission line may vary to a large extent, from a few kilometers, or even shorter, up to hundreds of kilometers.

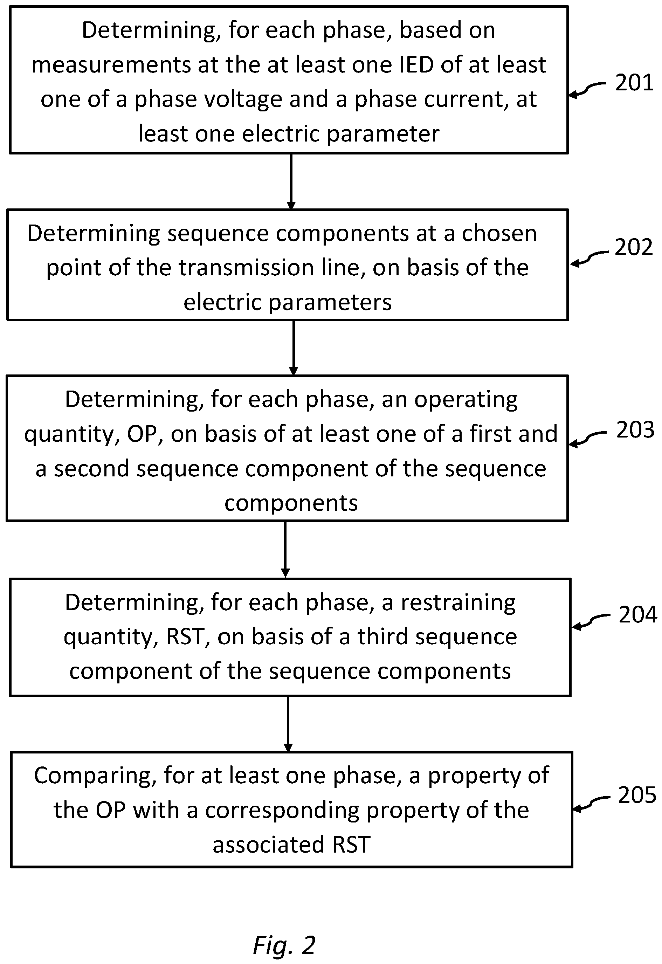

According to exemplifying embodiments of the present method of detecting a fault in the protected line 114, the method comprises operations as illustrated in the flow chart of Fig. 2. In a box 201, a voltage and/or a current, is measured at the IED 111 for each phase. The protected line 114 typically has three phases, but the method is applicable also to transmission systems with other numbers of phases, fewer as well as more. Thus, one or more phase voltages and/or phase currents have been measured. An electric parameter is determined for each phase, based on the measurements at the IED. For instance, the electric parameter may be a phasor of the phase voltage or phase current, for each phase. As known to the person skilled in the art, the phasor is a vector representation, which can be mathematically expressed as a complex number containing a magnitude and a phase angle. As an alternative, the electric parameter may be a basic time domain representation of the phase voltage or phase current.

Next, in box 202, on basis of the electric parameters, sequence components are determined at a chosen point of the transmission line.

According to the present example, the method further comprises, in 203, determining, for each phase, an operating quantity, OP, on basis of at least one of a first and a second sequence component of the sequence components. Typically, the operating quantity OP is based on one or two sequence components that are significant only when a fault has occurred.

Similarly, for each phase, a restraining quantity, RST, is determined on basis of a third sequence component of the sequence components, in 204. Typically, the restraining quantity is based on a sequence component that is significant when there is no fault on the transmission line 101.

Furthermore, in 205, a comparison of a property of the OP with a corresponding property of the RST for at least one phase is performed. The RST is an associated RST, i.e. the RST which has been determined for the same phase as the OP with which it is compared. The comparison is made in such a way that the result indicates if a fault property is at hand or not. For instance, the fault property can be that a fault has occurred, or in which phase the fault has occurred, etc., as will be further described below. This comparison may be regarded as at least a part of a fault criterion.

When the fault criterion has been fulfilled, conventional operations for handling the fault are performed, such as opening suitablebreakers, etc., as known to the person skilled in the art.

The sequence components may, for instance, be determined for positive, negative, and zero sequence, which can be present in a three-phase system. In a two-phase system, for instance only positive sequence and zero sequence can be present.

For a phasor notation, the fundamental frequency phasors for three-phase voltage and current signals shall be derived. For instance, the measured voltages and currents are sampled and a full cycle Discrete Fourier Transform (DFT) filter, or some other appropriate type of filtering, may be applied. Then the sequence components for the phase currents and the phase voltages of a three-phase transmission line can be determined by matrix calculations according to:

$$\begin{pmatrix} I_0 \\ I_1 \\ I_2 \end{pmatrix} = \frac{1}{3} * \begin{pmatrix} 1 & 1 & 1 \\ 1 & a & a^2 \\ 1 & a^2 & a \end{pmatrix} * \begin{pmatrix} I_A \\ I_B \\ I_C \end{pmatrix}$$

$$\begin{pmatrix} U_0 \\ U_1 \\ U_2 \end{pmatrix} = \frac{1}{3} * \begin{pmatrix} 1 & 1 & 1 \\ 1 & a & a^2 \\ 1 & a^2 & a \end{pmatrix} * \begin{pmatrix} U_A \\ U_B \\ U_C \end{pmatrix}$$

where the three phases are indexed by A, B, and C, and the positive, negative and zero sequences are indexed by 1, 2, and 0, respectively. The factor a is a complex operator, such that $a = e^{i*120°}$, and $i^2 = -1$.

The operating quantity OP could, for example, be based on $U_2$ and $U_0$, and the corresponding restraining quantity RST on $U_1$.

In the following, examples will be given on not only the very detection of a fault as such, but also other properties of the protected line 114 related to the fault, for instance, in which phase or phases the fault has occurred, and whether the fault is located within the protected line or not. In the examples of fault detection within the scope of the present method it is assumed that the protected line 114 contains three phases A, B, C.

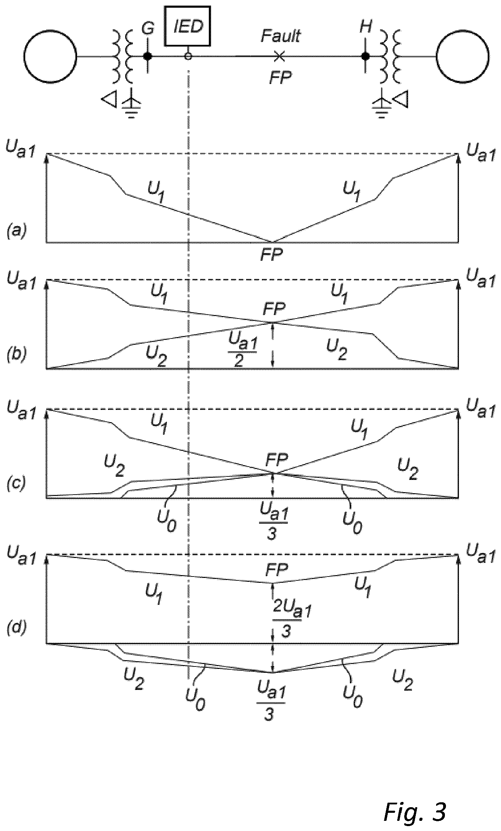

However, before describing the more detailed examples of how the method operates, it is referred to Fig. 3, which illustrates how the sequence voltages behave when different types of faults occur along the protected line 114. The top graph shows a three-phase fault, i.e. when all three phases are affected by the same fault. Only the positive sequence voltage $U_1$ is non-zero somewhere, but its magnitude is decreasing from a maximum value at the end points to zero at the fault point. In the second to top graph the sequence voltages at a phase-to-phase, i.e. two-phase, fault are shown. The positive and negative sequence voltages are present, and at the fault point they are equal. The third to top graph represents a two-phases-to-ground fault, where all three sequence voltages are non-zero. At the fault point they are all equal, the magnitude of the positive sequence voltage increases from the fault point towards the ends of the protected line, while the magnitudes of the other two sequence voltages decrease towards the ends. The bottom graph illustrates a phase-to-ground fault.

In a first example the chosen point of the protected line 114 is at the IED 111, and the criterion is configured for determining in which phase the fault has occurred. This fault determination inherently includes the determination that a fault has occurred. The operation quantities $OP_A@IED$, $OP_B@IED$, and $OP_C@IED$ for the three phases are based on the negative sequence voltage $U_2$ and the zero sequence voltage $U_0$, and they are determined as follows:

$$\left|OP_A@IED = U_2@IED + U_0@IED\right.$$

$$OP_B@IED = a * U_2@IED + U_0@IED$$

$$OP_C@IED = a^2 * U_2@IED + U_0@IED$$

Thus, the operation quantities OP represent a sum of the negative and zero sequence voltages per phase at the IED location, and they will exist for all kinds of phase-to-phase and phase-to-ground faults except for a three-phase fault. Corresponding restraining quantities $RST_A@IED$, $RST_B@IED$, and $RST_C@IED$ are based on the positive sequence voltage $U_1$, and they are determined as follows:

$$RST_A@IED = U_1@IED$$

$$RST_B@IED = a^2 * U_1@IED$$

$$RST_C@IED = a * U_1@IED$$

All three restraining quantities have the same magnitude, but not the same phase angle, they are 120 degrees apart. Proper use of the "a" operator is required to derive six operating and restraining quantities.

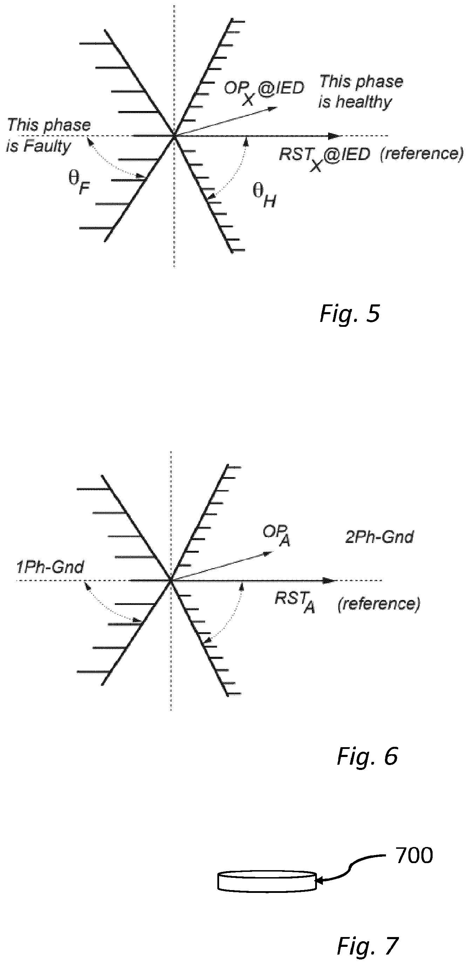

The determination of whether a fault criterion is fulfilled comprises determining, for each operating quantity, OP, i.e. $OP_A@IED$, $OP_B@IED$, and $OP_C@IED$, a phase angle difference between the OP and its corresponding restraining quantity RST, i.e. $RST_A@IED$, $RST_B@IED$, and $RST_C@IED$. Further, the criterion comprises that a fault has occurred in the phase that the OP relates to if the phase angle difference is within a fault interval around 180 degrees. For instance, the example operating quantity $OP_A@IED$ is related to the phase denoted A. With reference to Fig. 5, the fault interval is 180 degrees plus and minus a fault angle $\ominus_F$, i.e. $180 \pm \ominus_F$, where $\ominus_F = 75$ degrees. Similarly, the phase is healthy, i.e. free from faults, if the phase angle difference is within a health interval around 0 degrees. More particularly, for a health angle $\ominus_H$ the health interval can be expressed as $0 \pm \ominus_H$, where $\ominus_H = 75$ degrees. The fault interval as well as the health interval can be up to 90 degrees, but due to possible errors in the measurements it is preferred, at the time being, to use more narrow intervals as mentioned above. The intervals can be chosen even more narrow if desired, such as 45 degrees or 30 degrees, etc. The choice of angle of the interval can be made with respect to different conditions. For instance, the system that the present method is applied on may be given an impact, as well as required speed of fault detection, accuracy of measurements, etc.

A futher condition may be used in order to increase the reliability of the above determination of which phase/phase is/are faulty. More particularly, the above-mentioned criterion may comprise that a fault has occurred if a magnitude of the OP and a magnitude of the associated RST both exceed a threshold. The threshold can be, for instance, 5% of a rated phase-to-ground voltage. The above determinations of operating quantities, restraining quantities, their inter-relationships, and their relations with the threshold are continuously performed in order to provide a fast fault response and minimize the damages that the fault could cause of not attended to.

In a second example the chosen point of the protected line 114 is again at the IED 111, and the criterion is configured for determining in which phase the fault has occurred. This fault determination inherently includes the determination that a fault has occurred. The operating quantities $OPI_A@IED$, $OPI_B@IED$, and $OPI_C@IED$ for the three phases are based on the negative sequence current $I_2$ and the zero sequence current $I_0$, and they are determined as follows:

$$OPI_A@IED = I_2@IED + I_0@IED$$

$$OPI_B@IED = a * I_2@IED + I_0@IED$$

$$OPI_C@IED = a^2 * I_2@IED + I_0@IED$$

The corresponding restraining quantities are determined as follows:

$$RSTI_A@IED = -I_1@IED$$

$$RSTI_B@IED = -a^2 * I_1@IED$$

$$RSTI_C@IED = -a * I_1@IED$$

Consequently, in this example, the electric parameters are based on the phase currents. As in the first example above, the phase angle difference between the respective operating quantity $OPI_A@IED$, $OPI_B@IED$, and $OPI_C@IED$ and the corresponding restraining quantity $RSTI_A@IED$, $RSTI_B@IED$, $RSTI_C@IED$, respectively, is determined and if within the same fault interval as described above, and illustrated in Fig. 5, a phase where a fault has occurred is detected.

Further conditions may be added to the fault criterion. One additional condition may be that the magnitudes of both the operational quantity OP and its corresponding restraining quantity RST are above a predetermined threshold, for instance 25% of the rated phase current. Only if that condition is fulfilled it is determined that a fault has occurred. Another additional condition comprised in the fault criterion, may be that the conclusion that a fault has occurred is conditioned by a combination of the maximum phase current measured at the IED exceeding a first threshold, such as 200% of the rated phase current, and at the same time the magnitudes of both the operating quantity and the restraining quantity for any one of the phase voltages exceed a second threshold, such as 25% of the rated phase voltage.

In a third example, the determinations of faults are made by means of values related to a reach point RP. The reach point RP is an imaginary point at a distance from the IED 111 along the protected line 114, or even beyond the protected line, as will be evident below. Thus, there are no further measurements made at the RP but the values at RP are estimated on basis of the measurements at the IED 111 and necessary line parameters of the transmission line 101. The line parameters include, but are not limited to, line impedances, such as a line positive sequence impedance $Z_{1L}$, and a line zero sequence impedance $Z_{0L}$. If a parallel transmission line exists, which is not shown in the figures, a line mutual zero sequence impedance $Z_{ML}$ may be used as well. The line parameters are known since they are pre-determined and noted by the transmission system provider. When estimating values at RP the aim is to detect if the fault is on the protected line based on only local measurements. This may be done by defining one or more distance protection zones. For instance, two protection zones may be defined, where the first protection zone covers 80% of the protected line 114 and the second protection zone covers 120% of the protected line 114. In the calculations the protection zone is represented by a reach factor $r$, which will be 0.8 for the 80% case and 1.2 for the 120% case. In other words, the reach factor $r$ is related to the distance from the measurement point, i.e. at the IED 111, and typically where the IED 111 is connected to the transmission line 101, to the reach point RP. The sequence currents and sequence voltages at the reach point RP are determined according to:

$$U_1@RP = U_1@IED - r * Z_{1L} * I_1@IED$$

$$U_2@RP = U_2@IED - r * Z_{1L} * I_2@IED$$

$$U_0@RP = U_0@IED - r * Z_{0L} * I_0@IED$$

$$I_1@RP = I_1@IED$$

$$I_2@RP = I_2@IED$$

$$I_0@RP = I_0@IED$$

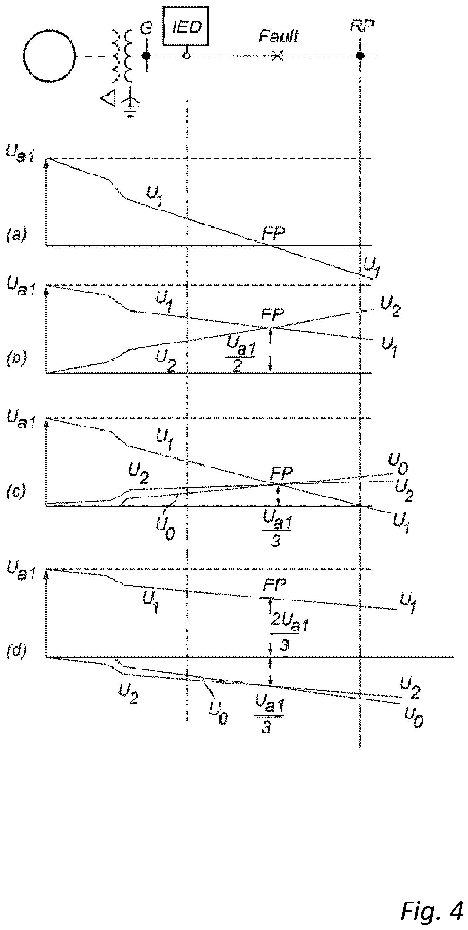

This example is simplified in that, inter alia, the shunt capacitance of the transmission line 101/protected line 114 is not taken into account. However, that is not absolutely necessary to detect a fault within the set protection zone and determine other properties of the fault. Furthermore, it should be noted that other more complicated methods could be used as well to estimate sequence voltages and currents at the reach point, e.g. by using two port equivalent networks, line telegraphic equations, etc, taking also the shunt capacitance into account. Assuming that the fault occurs at a point between the measurement point at the IED 111 and the reach point RP, the estimated sequence voltages will go through the fault point FP and may change sign, as shown in the upper most graph in Fig. 4. As illustrated in Fig. 3, this does not happen in the real system, it is a result of the estimation. However, that can be accounted for in the determinations of properties of the faults. Some further notes should be made as regards the estimations of the voltage values at the reach point RP as follows:

1) The magnitude of the positive sequence voltage at the reach point RP will be even lower than at the fault point FP when fault location is inbetween IED and the RP. That is not physically possible, i.e. such a location does not exist in the real faulty transmission system 100 but it is caused by the applied estimation.

2) Magnitudes of the negative and zero sequence voltages at the reach point RP will be larger than at the fault point FP when a fault is located inbetween IED and the reach point RP. That is also not physically possible but it is caused by the applied estimation.

3) For a 3-phase fault, i.e. the top most graph, the positive sequence voltage $U_1$ at the reach point RP will have 180 degrees phase shift from the positive sequence voltage $U_1$ measured by the IED, i.e. it becomes inverted. As already noted above that does not occur in reality.

4) This inversion of the positive sequence voltage can even happen for a 2-phase or even a 1-phase fault if the fault point FP is very close to the IED and the reach point RP is quite remote from the IED. However, such positive sequence voltage inversion at the reach point RP also means that the fault is definitely within the set reach of the distance protection, i.e. within the protected zone.

Based on the above information and the estimations of the sequence voltages at the reach point RP it is possible to determine different properties of the protected line related to the faults by means of operating quantities and restraining quantities determined on basis of the sequence voltages.

The operating quantities per phase at the reach point RP, $OP_A@RP$, $OP_B@RP$, and $OP_C@RP$, are determined according to:

$$OP_A@RP = U_2@RP + U_0@RP$$

$$OP_B@RP = a * U_2@RP + U_0@RP$$

$$OP_C@RP = a^2 * U_2@RP + U_0@RP$$

Thus, the operating quantities $OP_A@RP$, $OP_B@RP$, and $OP_C@RP$, like in the first example, are based on a sum of negative and zero sequence voltages. The corresponding restraining quantities at the reach point, $RST_A@RP$, $RST_B@RP$, and $RST_C@RP$ are determined according to:

$$RST_A@RP = U_1@RP$$

$$RST_B@RP = a^2 * U_1@RP$$

$$RST_C@RP = a * U_1@RP$$

In this third example, it is also determined in which phase, or phases, a fault has occurred. Similar to the first example, a phase angle difference between the operating quantity and the corresponding restraining quantity is determined. However, first it is determined if a magnitude of at least one of the operating quantities $OP_A@RP$, $OP_B@RP$, and $OP_C@RP$ exceeds a minimum threshold level, such as for example 5% of the rated phase voltage. If affirmative, which it will be for all unsymmetrical faults, it is decided that a fault has occurred.

Then it is determined which operating quantity has the largest magnitude. The type of the fault and consequently faulty phases can then be determined by doing the above comparison between the phase angles of the Operating and Restraining quantities for the phase having the largest magnitude of the operating quantity. For instance, assume that the operating quantity related to phase A has the largest magnitude, i.e. $OP_A@RP > OP_B@RP$ AND $OP_A@RP > OP_C@RP$. The phase angle comparison is shown in Figure 6. The comparison can be referred to as a directional comparison. The following principles are valid for this phase angle comparison:

1) If the Operating quantity $OP_A@RP$ is approximately in contra-phase from the Restraining quantity $RST_A@RP$, or within an interval thereabout, i.e. the phase angle difference is within an interval around, 180 degrees, then the fault is an A-Phase-to-Ground fault (i.e. 1-Phase-to-ground in the as shown at the left side in the graph in Fig. 6.

2) If the Operating quantity $OP_A@RP$ is approxaimately in phase with the Restraining quantity $RST_A@RP$, or within an interval thereabout, i.e. the phase angle difference is within an interval around 0 degrees, then the fault is a B-C-Gnd fault, i.e. in the other two phases, as shown at the right side of the graph in Fig. 6.

In addition to the fault determinations above, based on operating and restraining quantities, which in turn are based on sequence components of voltages or currents, it can be determined whether a fault has occurred in a forward direction or in a reverse direction along the transmission line 101. A group of relations can be defined as follows:

$$U_1@IED \geq U_1@RP,$$

$$U_2@IED \leq U_2@RP,$$

and

$$U_0@IED \leq U_0@RP,$$

wherein $U_1@IED$, $U_2@IED$, $U_0@IED$ are respective magnitudes of the sequence voltages at the IED, and $U_1@RP$, $U_2@RP$, and $U_0@RP$ are respective magnitudes of the sequence voltages at the reach point RP. At least two of the relations are used for the determination. The criterion comprises that the fault is in forward direction, i.e. in direction from the IED towards the reach point, if the at least two relations are true, and that the fault is in reverse direction if the at least two relations are false.

Furthermore, it can be determined that an unsymmetrical fault has happened within the protection zone if the magnitude of the Operating quantity at reach point is bigger than the magnitude of the corresponding Restraining quantity at reach point, i.e. $OP_X@RP > RST_X@RP$ for $X=A, B,$ or $C$, for any of the faulty phases. Which phase is faulty is determined as described above. When inversion of the positive sequence voltage phasor at the reach point RP has happened, then a three-phase fault is within the protection zone if all operating quantities related to voltages have small magnitudes, e.g. <5% of the rated phase voltage.

Figure 7 most schematically illustrates that as an aspect of the present disclosure, there is provided a computer program product 700 comprising instructions which, when downloaded into an intelligent electronic device, connectable to a transmission line of a power transmission system, cause the intelligent electronic device to carry out the method set forth above.

**Claims**

1. A method of detecting a fault in a protected line (114) constituting at least a portion of a transmission line (101) in an alternating current, AC, power transmission system (100), the transmission line having at least one phase, and the AC power transmission system having at least one intelligent electric device, IED, (111, 112) connected with the transmission line, the method comprising:

    - determining, for each phase, based on measurements at the at least one IED of at least one of a phase voltage and a phase current, at least one electric parameter;
    - determining sequence components at a chosen point of the transmission line, on basis of the electric parameters;
    - determining, for each phase, an operating quantity, OP, on basis of at least one of a first and a second sequence component of the sequence components;
    - determining, for each phase, a restraining quantity, RST, on basis of a third sequence component of the sequence components; and
    - comparing, for at least one phase, a property of the OP with a corresponding property of an associated RST, which is the RST for the same phase as the OP.

2. The method according to claim 1, wherein the chosen point of the transmission line is a reach point, RP, at a distance from the IED, further comprising determining whether at least one OP has a value exceeding a first threshold.

3. The method according to claim 1 or 2, wherein the chosen point of the transmission line is a reach point, RP, at a distance from the IED, further comprising determining in which phase the fault has occurred.

4. The method according to claim 3, said determining in which phase the fault has occurred comprising:

    - selecting the OP which has the largest value;
    - determining a phase angle difference between the selected OP and the associated RST;
    - wherein the fault has occurred in the phase that the OP relates to if a phase angle difference is within a fault interval around 180 degrees.

5. The method according to claim 4, wherein the fault has occurred in at least one of the other phases if the phase angle difference is within a fault interval around 0 degrees.

6. The method according to claim 1, wherein the chosen point of the transmission line is at the IED, further comprising determining in which phase the fault has occurred.

7. The method according to claim 6, said determining in which phase the fault has occurred comprising:

    - determining, for each OP, a phase angle difference between the OP and the associated RST;
    - wherein the fault has occurred in the phase that the OP relates to if the phase angle difference is within a fault interval around 180 degrees.

8. The method according to claim 7, said determining in which phase the fault has occurred being preceded by determining whether a magnitude of the OP and a magnitude of the associated RST, for at least one of the phases, both exceed a second threshold, and, if affirmative, determining that a fault has occurred.

9. The method according to claim 1, said at least one electric parameter being based on a phase current, comprising determining whether a magnitude of the OP and a magnitude of the associated RST, related to at least one phase, both exceed a third threshold, and whether a maximum phase current exceeds a fourth threshold.

10. The method according to any one of claims 1 to 5, wherein the chosen point of the transmission line is a reach point, RP, at a distance from the IED, comprising determining whether a magnitude of the OP is bigger than a magnitude of the associated RST, and, if affirmative, determining that an unsymmetrical fault has occurred within a set reach of the distance protection.

**11.** The method according to any one of claims 1 to 10, wherein the chosen point of the transmission line is at the IED, comprising determining whether a fault has occurred in a forward direction or in a reverse direction along the transmission line, comprising determining at least two relations of a group of relations comprising:

$$U_1@IED \geq U_1@RP,$$

$$U_2@IED \leq U_2@RP,$$

and

$$U_0@IED \leq U_0@RP,$$

wherein $U_1@IED$, $U_2@IED$, $U_0@IED$ are respective magnitudes of the sequence voltages at the IED, and $U_1@RP$, $U_2@RP$, and $U_0@RP$ are respective magnitudes of the sequence voltages at a reach point at a distance from the IED, and

determining that the fault is in forward direction if the at least two relations are true, and that the fault is in reverse direction if the at least two relations are false.

**12.** The method according to any one of the preceding claims, said determining, for each phase, at least one electric parameter comprising determining a phasor for each electric parameter.

**13.** The method according to any one of the preceding claims, wherein the operation of determining sequence components comprises determining sequence components for positive, negative, and zero sequence.

**14.** The method according to claim 13, wherein the first and second sequence components are for the negative and zero sequences, and the third sequence component is for the positive sequence.

**15.** A computer program product comprising instructions which, when downloaded into an intelligent electronic device, connectable to a transmission line of a power transmission system, cause the intelligent electronic device to carry out the method of any one of claims 1 to 14.

*Fig. 1*

Determining, for each phase, based on measurements at the at least one IED of at least one of a phase voltage and a phase current, at least one electric parameter — 201

Determining sequence components at a chosen point of the transmission line, on basis of the electric parameters — 202

Determining, for each phase, an operating quantity, OP, on basis of at least one of a first and a second sequence component of the sequence components — 203

Determining, for each phase, a restraining quantity, RST, on basis of a third sequence component of the sequence components — 204

Comparing, for at least one phase, a property of the OP with a corresponding property of the associated RST — 205

*Fig. 2*

Fig. 3

Fig. 4

OP$_X$@IED    This phase
is healthy

This phase
is Faulty

RST$_X$@IED  (reference)

$\theta_F$

$\theta_H$

Fig. 5

1Ph-Gnd

OP$_A$    2Ph-Gnd

RST$_A$   (reference)

Fig. 6

700

Fig. 7

14

Europäisches
Patentamt

European
Patent Office

Office européen
des brevets

# EUROPEAN SEARCH REPORT

Application Number

EP 23 15 4525

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 091 433 A (WILKINSON STANLEY B) 23 May 1978 (1978-05-23) | 1,8-10, 15 | INV. H02H3/40 |
| Y | * column 4, line 20 – column 6, line 38; figures 1, 6-15 * | 2-5 | H02H3/38 G01R31/08 |
| X | EP 2 112 517 A1 (UNIV PAIS VASCO [ES]) 28 October 2009 (2009-10-28) * paragraphs [0038] – [0043]; figure 1 * | 1,6-8, 11-14 | |
| Y | US 2020/319262 A1 (LI YOUYI [SE] ET AL) 8 October 2020 (2020-10-08) * paragraphs [0033] – [0037], [0082] – [0088]; figures 1-3, 7 * | 2-5 | |
| X | US 2020/103455 A1 (KASZTENNY BOGDAN Z [CA] ET AL) 2 April 2020 (2020-04-02) * paragraphs [0020] – [0029]; figure 1 * | 1 | |

TECHNICAL FIELDS
SEARCHED (IPC)

H02H
G01R

The present search report has been drawn up for all claims

| Place of search | Date of completion of the search | Examiner |
|---|---|---|
| Munich | 1 August 2023 | Colombo, Alessandro |

EPO FORM 1503 03.82 (P04C01)

## ANNEX TO THE EUROPEAN SEARCH REPORT
## ON EUROPEAN PATENT APPLICATION NO.

EP 23 15 4525

This annex lists the patent family members relating to the patent documents cited in the above-mentioned European search report.
The members are as contained in the European Patent Office EDP file on
The European Patent Office is in no way liable for these particulars which are merely given for the purpose of information.

01-08-2023

| Patent document cited in search report | | Publication date | Patent family member(s) | | Publication date |
|---|---|---|---|---|---|
| US 4091433 | A | 23-05-1978 | BR | 7800833 A | 07-11-1978 |
| | | | DE | 2805094 A1 | 17-08-1978 |
| | | | ES | 466743 A1 | 16-10-1978 |
| | | | FR | 2385247 A1 | 20-10-1978 |
| | | | GB | 1590665 A | 03-06-1981 |
| | | | JP | S53109145 A | 22-09-1978 |
| | | | US | 4091433 A | 23-05-1978 |
| | | | ZA | 7880 B | 29-11-1978 |
| EP 2112517 | A1 | 28-10-2009 | EP | 2112517 A1 | 28-10-2009 |
| | | | ES | 2308913 A1 | 01-12-2008 |
| | | | WO | 2008099037 A1 | 21-08-2008 |
| US 2020319262 | A1 | 08-10-2020 | CN | 111796202 A | 20-10-2020 |
| | | | EP | 3723224 A1 | 14-10-2020 |
| | | | US | 2020319262 A1 | 08-10-2020 |
| US 2020103455 | A1 | 02-04-2020 | NONE | | |

EPO FORM P0459

For more details about this annex : see Official Journal of the European Patent Office, No. 12/82